# FASCICULE DE BREVET EUROPEEN

(11) **EP 2 801 104 B1**
(45) Date de publication et mention de la délivrance du brevet: **09.06.2021**
(21) Numéro de dépôt: 12806553.9
(22) Date de dépôt: 22.11.2012
(51) Int. Cl.: H01L 21/02, H01L 21/36

(54) **INTERFACE PERFECTIONNÉE ENTRE UNE COUCHE I-III-VI2 ET UNE COUCHE DE CONTACT ARRIÈRE, DANS UNE CELLULE PHOTOVOLTAÏQUE**
VERBESSERTE SCHNITTSTELLE ZWISCHEN EINER I/III/VI-2-SCHICHT UND EINER RÜCKSEITIGEN KONTAKTSCHICHT BEI EINER FOTOVOLTAISCHEN ZELLE
IMPROVED INTERFACE BETWEEN A I/III/VI2 LAYER AND A BACK CONTACT LAYER IN A PHOTOVOLTAIC CELL

(30) Priorité: 05.12.2011 FR 1161172
(43) Date de publication de la demande: 12.11.2014
(73) Titulaire: Electricité de France, 75008 Paris (FR)
(72) Inventeur: ANGLE, Stéphanie, F-13106 Rousset (FR); PARISSI, Ludovic, F-13106 Rousset (FR)
(74) Mandataire: Plasseraud IP
(86) Numéro de dépôt international: PCT/FR2012/052703
(87) Numéro de publication internationale: WO 2013/083897

(56) Documents cités:
- US-A1- 2010 258 191
- US-A1- 2010 297 835
- US-A1- 2010 317 144
- SONG S ET AL: "Diffusion barrier performances of thin Mo, Mo-N and Mo/Mo-N films between Cu and Si", THIN SOLID FILMS, ELSEVIER-SEQUOIA S.A. LAUSANNE, CH, vol. 476, no. 1, 1 avril 2005 (2005-04-01) , pages 142-147, XP027865109, ISSN: 0040-6090 [extrait le 2005-04-01]
- PATRICK BLÖSCH ET AL: "Comparative Study of Different Back-Contact Designs for High-Efficiency CIGS Solar Cells on Stainless Steel Foils", IEEE JOURNAL OF PHOTOVOLTAICS, I E E E, US, vol. 1, no. 2, 1 octobre 2011 (2011-10-01) , pages 194-199, XP011390833, ISSN: 2156-3381, DOI: 10.1109/JPHOTOV.2011.2166589
- KAELIN M ET AL: "Low cost processing of CIGS thin film solar cells", SOLAR ENERGY, PERGAMON PRESS. OXFORD, GB, vol. 77, no. 6, 1 December 2004 (2004-12-01), pages 749-756, XP004661815, ISSN: 0038-092X, DOI: 10.1016/J.SOLENER.2004.08.015

## Description

La présente invention concerne la fabrication d'une couche I-III-VI₂ à propriétés photovoltaïques, notamment mais non limitativement pour des applications dans des cellules solaires.

En effet, un matériau de stœchiométrie égale ou voisine de I-III-VI₂, sous forme de couche mince absorbante de lumière, convient pour des applications dans des de telles cellules. L'élément I peut être par exemple du cuivre Cu (colonne I de la classification périodique). L'élément III peut être par exemple de l'indium In, du gallium Ga, ou encore de l'aluminium Al (colonne III de la classification périodique). L'élément VI peut être par exemple du soufre S ou du Sélénium Se (colonne VI de la classification périodique). L'ensemble de l'alliage I-III-VI₂ est communément appelé CIGS (avec C pour cuivre, I pour indium, G pour gallium, et S pour soufre et/ou sélénium).

Dans un procédé avantageux (car économique et facile à mettre en œuvre industriellement), les éléments I et III sont déposés en tant que précurseurs, par exemple par électrolyse ou par pulvérisation cathodique, sur une couche mince métallique de contact électrique arrière, cette couche étant souvent du molybdène Mo (appelé plus généralement « métal » ci-après). Cette couche de contact est préalablement déposée, par exemple par pulvérisation cathodique, sur un substrat métallique, ou encore sur un substrat en verre, (appelé plus généralement « substrat » ci-après).

Ensuite, l'élément VI est apporté par réaction à haute température avec les précurseurs I-III, par exemple dans un four comportant une atmosphère de soufre et/ou de sélénium. Cette étape est appelée ci-après « sulfuration » ou « sélénisation ». L'alliage cristallin obtenu, de composition I-III-VI₂, possède une structure de type chalcopyrite et la formation de ce composé est appelée ci-après « chalcogénisation ». Un tel alliage possède avantageusement des propriétés photovoltaïques et son intégration sous forme de couche mince en fait un matériau de choix pour la fabrication de cellules photovoltaïques.

Il a été observé qu'il peut se former spontanément, pendant l'étape de sélénisation et/ou sulfuration pour la formation de l'alliage photovoltaïque, une couche naturelle d'un composé résultant d'une combinaison du métal de la couche de contact et de l'élément VI apporté pendant cette étape. Par exemple, dans le cas où le métal de la couche de contact est du molybdène et l'élément VI est du sélénium, il peut être observé la formation naturelle d'une couche de MoSe₂ pendant la sélénisation, à l'interface entre le molybdène de la couche de contact, d'une part, et le CIGS au-dessus, d'autre part, le sélénium venant réagir avec le métal Mo de la couche de contact.

Ainsi, l'élément VI peut diffuser dans la couche de contact pendant le traitement thermique, en se combinant avec le métal pour former une couche superficielle sur la couche de contact.

Cette couche superficielle (par exemple non limitativement du MoSe₂) est bénéfique à de nombreux égards.

Par exemple, cette couche superficielle facilite avantageusement un contact électrique quasi-ohmique entre la couche I-III-VI₂ et le métal de la couche de contact. Le contrôle de son épaisseur et de sa morphologie, notamment son orientation cristalline, déterminent les propriétés d'adhérence et les propriétés électriques de l'interface entre la couche I-III-VI₂ et la couche de contact.

Elle joue aussi un rôle pour optimiser un procédé de gravure par faisceau laser, notamment de la couche I-III-VI₂.

Toutefois, il convient de maîtriser les propriétés de cette couche superficielle, notamment en morphologie et/ou en épaisseur, pour s'assurer notamment d'une uniformité de ces propriétés dans le plan de la couche (uniformité dans le plan (X,Y), l'axe Z étant l'axe de croissance des couches).

Le document US2010/258191 A1 divulgue un procédé de fabrication d'une couche de séléniure de cuivre et d'indium à propriétés photovoltaïques, comportant :le dépôt sur un substrat de molybdène pour former une couche de contact,le dépôt comprenant une étape pendant laquelle un élément additionnel est ajouté au molybdène pour former un composé dans la couche de contact, et le dépôt d'une couche de séléniure de cuivre et d'indium sur la couche de contact.

La présente invention vient améliorer la situation.

Elle propose à cet effet un procédé de fabrication d'une couche I-III-VI₂ à propriétés photovoltaïques selon la revendication 1.

Comme indiqué ci-avant, l'élément VI diffuse dans la couche de contact pendant le traitement thermique et se combine avec le molybdène pour former une couche superficielle, du type précité, sur la couche de contact.

Dans le procédé au sens de l'invention, le dépôt de molybdène comprend une étape pendant laquelle un élément additionnel est ajouté au molybdène pour former un composé, dans la couche de contact, jouant le rôle de barrière de diffusion à l'élément VI, notamment pour contrôler les propriétés de la couche superficielle, en épaisseur et/ou en morphologie.

Un avantage de la présente invention consiste en ce que la barrière de diffusion à l'élément VI peut finalement se former simplement pendant l'opération générale de dépôt du molybdène. Par exemple, dans le cas où le dépôt de molybdène s'effectue dans un bâti sous vide, l'élément additionnel est inclus dans la couche de molybdène pendant une des étapes de dépôt du molybdène, sans remise à l'atmosphère, ni changement de bâti. Il suffit simplement d'introduire dans le même bâti l'élément additionnel pendant l'étape de dépôt de la couche barrière, comme on le verra dans quelques exemples de réalisation ci-après.

Par exemple, le dépôt de molybdène peut s'effectuer sous vide suivant la technique de pulvérisation cathodique d'une cible avec un plasma froid d'un gaz porteur (en général l'argon). Cette technique est habituellement appelée « sputtering » en anglais (ou encore « PVD » pour « Physical Vapor Déposition »). Dans un mode de réalisation où l'élément additionnel est par exemple de l'azote (ou encore, en variante, de l'oxygène), il est possible d'ajouter l'élément additionnel au gaz porteur du plasma. Il s'agit alors d'une pulvérisation cathodique dite « réactive » de la cible de molybdène.

Ainsi, pendant l'étape de dépôt de la couche barrière précitée, un mélange dans le gaz de plasma comporte :
- de l'argon et
- par exemple de l'azote
(par exemple dans une proportion de 10 à 50% et plus particulièrement dans une gamme de 15 à 25% d'azote).

Il est à noter qu'en variante, il est possible aussi de prévoir l'élément additionnel directement dans la cible et il est ainsi pulvérisé sur le substrat avec le molybdène, typiquement dans la proportion métal/élément additionnel définie par la composition de la cible.

Ainsi, en termes plus génériques, le molybdène est déposé par pulvérisation d'une cible comportant ledit métal, la pulvérisation étant alors effectuée à l'aide d'un plasma comportant ledit élément additionnel pour former la couche barrière et, dans une variante, de pulvériser, pendant l'étape précitée de formation de la couche barrière, une cible comportant du molybdène et l'élément additionnel (par exemple un autre métal tel que du titane, dont l'alliage avec le molybdène forme aussi une barrière au sélénium).

Dans une réalisation possible, cette étape de dépôt de la couche barrière peut être succédée d'un dépôt de molybdène sans l'élément additionnel, pour contrôler les propriétés de la couche superficielle.

Dans une variante, cette étape de dépôt de la couche barrière termine le dépôt général de la couche de contact. Une telle variante permet de limiter la couche superficielle à une très faible épaisseur (de l'ordre de quelques nanomètres dans l'exemple du MoSe₂).

Préférentiellement, l'étape précitée de dépôt de la couche barrière est précédée d'un dépôt du molybdène, sans l'élément additionnel précité, pour assurer notamment de bonnes propriétés de conduction de la couche de contact.

Par exemple, le molybdène peut être déposé par pulvérisation cathodique sur le substrat en effectuant plusieurs passages du substrat devant la même cible de métal ou un passage devant plusieurs cibles du métal sans rupture de vide. Par exemple, l'avant-dernier ou le dernier passage devant la cible de métal peut se faire par pulvérisation cathodique réactive pour former la couche barrière.

Selon l'invention, le métal de la couche de contact est du molybdène (déposé sur un substrat en verre ou en métal). Néanmoins, d'autres variantes utiles à la compréhension de l'invention sont possibles. Par exemple, dans le cas d'un substrat métal, on peut choisir une couche d'adaptation en nickel et le métal de la couche de contact précitée est alors du nickel. Dans d'autres variantes encore, aussi ne faisant pas partie de la présente invention, il peut s'agir de titane, de chrome, d'or et/ou de ruthénium (pour former des nitrures et/ou des oxydes de ces métaux, en tant que matériaux barrières).

Par ailleurs, l'élément additionnel peut être l'un au moins des éléments parmi :
- de l'azote, pour former un nitrure en tant que matériau barrière à la diffusion de l'élément VI,
- de l'oxygène, pour former un oxyde en tant que matériau barrière à la diffusion de l'élément VI, et
- un métal (par exemple du titane ou du chrome, ou autres) pour former un alliage en tant que matériau barrière à la diffusion de l'élément VI.

Comme indiqué ci-avant, l'élément VI peut être du sélénium (ou encore du soufre ou un mélange des deux espèces).

Le métal peut être déposé par exemple par pulvérisation d'une cible sous vide (par exemple par pulvérisation cathodique). Par exemple dans le cas où l'élément additionnel est de l'azote (ou de l'oxygène), comme indiqué ci-avant, le gaz de plasma (habituellement de l'argon) peut comporter une proportion d'azote (ou d'oxygène) dans une gamme comprise par exemple entre 10 et 50% (par exemple autour de 20% dans la gamme 15 à 25%).

Par exemple, si on applique habituellement à un substrat plusieurs passages successifs devant une cible de métal pulvérisée, ces différentes passages s'effectuent dans un plasma d'argon seulement, sauf par exemple pendant l'avant-dernier passage qui s'effectue devant une cible dudit métal pulvérisée par un plasma comportant un mélange d'argon et d'azote par exemple.

Il s'en suit alors un « empilement » comportant :
- une couche relativement épaisse de molybdène, assurant un bon contact arrière pour une future cellule photovoltaïque,
- une fine couche de nitrure de molybdène, formant barrière à la diffusion de l'élément VI, au-dessus de la couche épaisse, et
- une fine couche à nouveau de molybdène pur, qui a alors vocation à réagir avec l'élément VI pour former la couche superficielle précitée (par exemple de MoSe₂ si l'élément VI est du sélénium). Cette fine couche est dite alors « sacrificielle ».

Le précurseur, typiquement à base d'éléments I et III, peut être déposé par électrolyse. Par exemple, une technique consiste à déposer une couche de cuivre, puis une ou plusieurs couches d'éléments III (indium et/ou gallium) et à traiter thermiquement cet empilement en atmosphère d'élément VI.

Néanmoins, une variante possible consiste à déposer le précurseur par pulvérisation, avantageusement alors dans le même bâti de dépôt que pour l'obtention de la couche de contact (sans nécessiter encore de remise à l'air et de remise sous vide dans un second bâti). Il convient de préciser que, bien entendu, un vide absolu ne peut pas être obtenu dans un bâti de pulvérisation. Ainsi, par les termes « pulvérisation sous vide » ci-avant, on entend une mise sous vide suffisante pour éviter une contamination de la couche de métal en formation (par exemple une pression régnant dans le bâti, inférieure 10⁻⁵ bar).

Ainsi, la couche barrière constitue une signature de la mise en œuvre du procédé au sens de l'invention, dans une cellule photovoltaïque et en particulier, l'invention vise aussi une telle cellule photovoltaïque selon la revendication 9.

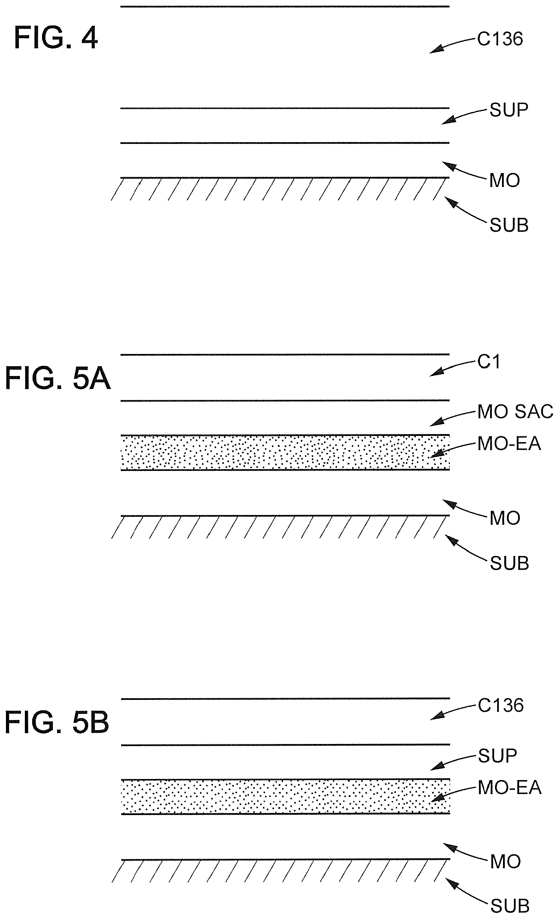

Une représentation partielle de la cellule au sens de l'invention peut être conforme à la figure 5B qui sera décrite plus loin, à titre d'exemple de réalisation.

D'ailleurs, d'autres avantages et caractéristiques de l'invention apparaîtront à la lecture de la description détaillée ci-après d'exemples de réalisation présentés à titre illustratif, aucunement limitatifs, et à l'examen des dessins annexés, sur lesquels :
- la figure 1 illustre un empilement de couches I et III, en tant que précurseur, conforme à un mode de réalisation du procédé présenté ci-avant,
- la figure 2 illustre un exemple de réalisation dans lequel on applique un premier traitement thermique au précurseur pour mélanger les espèces I et III,
- la figure 3 illustre un second traitement thermique en présence d'élément VI,
- la figure 4 illustre la couche d'alliage I-III-VI₂ (référence C136) finalement obtenue après le second traitement thermique,
- la figure 5A illustre un détail d'une couche de contact dans un exemple de réalisation de l'invention, dans un empilement correspondant à la figure 1,
- la figure 5B illustre un détail de la couche de contact au sens de l'invention, après le second traitement thermique correspondant à la figure 3,
- la figure 6 illustre schématiquement une installation pour la mise en oeuvre de l'invention,
- la figure 7 illustre des courbes comparatives de mesures SIMS (« Secondary Ion Mass Spectroscopy ») réalisées sur du sélénium (avec couche barrière : courbe 1 et sans couche barrière : courbe 2), la courbe 3 illustrant les mesures sur le molybdène et la courbe 4 les mesures sur l'azote, dans l'exemple de réalisation ici où l'élément ajouté au molybdène pendant le dépôt de la couche barrière est de l'azote.

Dans un exemple de réalisation, une couche de molybdène Mo est déposée, par exemple par pulvérisation cathodique (ou « sputtering », ou « PVD »), en tant que couche de contact arrière d'une cellule photovoltaïque. Son épaisseur est de l'ordre du micron, par exemple comprise entre 0,3 et 0,8 µm. Les particularités au sens de l'invention de mise en œuvre de ce premier dépôt seront décrites ultérieurement en référence aux figures 5A, 5B, 6 et 7.

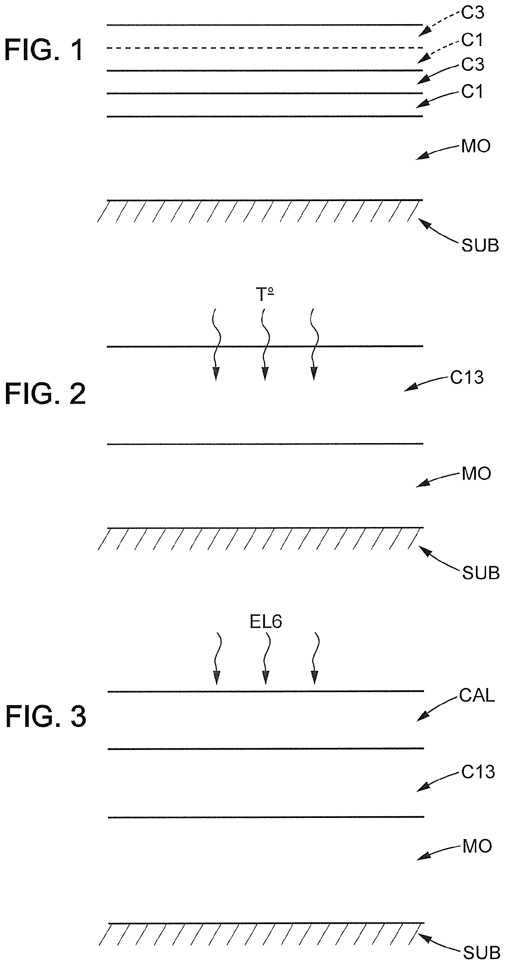

On dépose ensuite par électrolyse un empilement de plusieurs couches élémentaires I et III (C1 pour la couche d'élément I par exemple et C3 pour une couche d'élément III). On peut prévoir une alternance de couches C1 d'élément I et de couches C3 d'élément III (comme représenté sur la figure 1).

Dans une réalisation particulière décrite ci-après, on dépose par électrolyse l'empilement suivant :
- une couche de cuivre de 150 à 200 nm d'épaisseur,
- une couche d'indium de 300 à 500 nm,
- une couche de gallium de 100 à 200 nm.

L'empilement est recuit ensuite (flèches « T° » de la figure 2) avec des conditions de recuit à une température de l'ordre de 80°C à 120°C et pendant une durée de quelques dizaines de minutes (par exemple de l'ordre de 30 minutes), pour obtenir finalement une couche C13 de précurseur I-III.

En référence à la figure 3, on applique ensuite un traitement thermique avec apport en élément VI, tel que du soufre et/ou du sélénium (flèches « EL6 » de la figure 3). Les conditions d'apport en élément VI peuvent correspondre à un recuit avec une montée progressive à une température de l'ordre de 500 à 700°C en quelques minutes, avec injection de sélénium vapeur par exemple. Ainsi, le sélénium EL6 est apte à réagir avec le cuivre, l'indium et/ou le galium de la couche C13, pendant le maintien en température vers 500 à 700°C. En référence à la figure 4, on obtient finalement une couche C136 d'alliage I-III-VI₂ homogène et de bonne qualité. Néanmoins, l'élément VI réagit aussi avec le métal de la couche de contact et il se crée naturellement une couche superficielle SUP d'un composé métal-élément VI (par exemple MoSe₂).

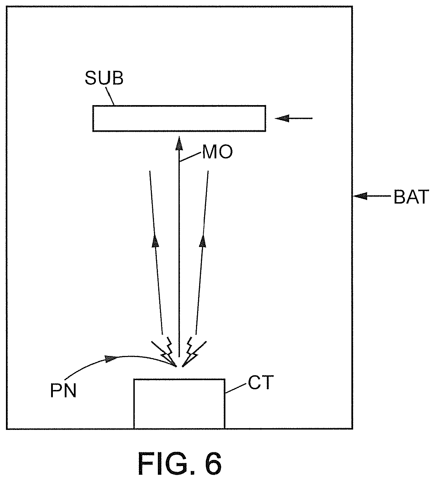

On cherche, au sens de l'invention, à contrôler les propriétés de cette couche SUP (notamment en épaisseur et en morphologie). On décrit maintenant en référence à la figure 6 un exemple de mode de réalisation à cet effet. Le substrat SUB peut être disposé sur un porte-échantillon mobile dans un bâti de dépôt de couches minces. Ce bâti BAT assure des conditions de très basse pression (« proche du vide », par exemple inférieure à 10⁻⁵ bar ; 1 bar équivaut à 100 kPa) pour éviter une contamination par des espèces non souhaitées des couches en cours de dépôt.

Le bâti comporte une source du métal à déposer (selon l'invention de molybdène), qui peut se présenter sous la forme d'une cible destinée à être pulvérisée sous l'action d'un plasma d'argon (ou autre gaz neure). Les atomes du métal ainsi pulvérisé se déposent sur le substrat SUB. Comme indiqué précédemment, on peut prévoir un déplacement du dispositif portant le substrat de manière à assurer notamment une homogénéité du dépôt de la couche de molybdène. Par exemple, il peut être prévu N passages du substrat SUB devant la source (avec par exemple N=4). Dans une réalisation au sens de l'invention, on prévoit alors qu'au cours de l'un au moins de ces passages (le j-ème passage), une proportion autour de 20% d'azote P_{N} est introduite dans le plasma.

On a représenté sur la figure 5A une vue en coupe d'un empilement de couches minces résultant d'une telle réalisation, tel qu'il se présente avant l'apport en élément VI. En particulier, la couche mince de molybdène Mo présente alors une structure comportant :
- du molybdène Mo (relativement « pur » ou tout au moins « conducteur ») sur le substrat SUB,
- un mélange MO-EA de molybdène et d'un élément additionnel, tel que l'azote dans l'exemple de réalisation décrit, ce mélange formant avantageusement une barrière à la migration de l'élément VI (par exemple le sélénium et/ou le soufre) pendant le traitement thermique de la figure 3,
- et à nouveau du molybdène Mo (dit « sacrificiel »), portant la référence SAC, à proximité de l'interface avec les futures couches I-III, avant traitement thermique.

Dans cet exemple de réalisation, on a par exemple N=4 et j=3 avec les notations utilisées précédemment en référence à la figure 6.

En référence maintenant à la figure 5B, après traitement thermique, il se forme au dessus de la barrière MO-EA une couche superficielle SUP, produit de la réaction du molybdène de la couche « *sacrificielle* » SAC et du sélénium par exemple issu de l'apport en élément VI (pendant une étape dite de « sélénisation »), de composition habituellement observée de type MoSe₂.

Il s'agit alors d'une couche superficielle SUP dont les propriétés (notamment son épaisseur et sa morphologie) sont finement contrôlées par la présence de la barrière MO-EA à la diffusion de l'élément VI.

On présente dans le tableau ci-après des caractéristiques détaillées d'un dépôt de couche de molybdène conforme au mode de réalisation schématisé sur la figure 6, tel qu'il se présente avant l'étape d'apport en élément VI (figure 5A).

| **Etape** | **Description** | **Mode ; Puissance ; Pression** | **Débit N₂ en % débit total Ar:N₂** | **Epaisseur** |
|---|---|---|---|---|
| Mo proche du substrat | Dépôt par PVD (« Physical Vapour Déposition) de molybdène « conducteur » | DC ; 5330W ; 5µbar | 0% | 450nm |
| Barrière MO-EA | Dépôt de molybdène partiellement nitruré | DC; 5330W ; 5µbar | 20% N₂ | 100nm |
| Couche sacrificielle | Dépôt par PVD de molybdène destiné à réagir avec le sélénium par exemple pour former le MoSe₂ | DC; 5330W ; 5µbar | 0% | 60nm |

Typiquement, avant traitement thermique de sélénisation (figure 5A), la couche de molybdène en contact avec le substrat peut être d'une épaisseur de l'ordre de 450 nm. Puis, la couche barrière MO-EA peut être d'une épaisseur inférieure à 100 nm, et la couche sacrificielle SAC peut être d'une épaisseur voisine de 60 nm.

Après traitement thermique de sélénisation (figure 5B), il s'est formé la couche superficielle SUP. Celle-ci présente une variation d'épaisseur dans le plan x,y de la couche (z étant l'axe de l'épaisseur de la couche), inférieure ou de l'ordre de 10%, d'après des mesures réalisées par microscopie électronique en transmission (TEM).

Une telle variation est très faible par rapport à celle d'une couche de MoSe₂ observée habituellement dans l'état de l'art (sans couche barrière). En particulier, une telle couche de MoSe₂ dans l'art antérieur présente une morphologie très inhomogène. Son épaisseur dans le plan x,y varie de façon anarchique et non uniforme. En revanche, la couche de MoSe₂ obtenue par le procédé de l'invention est plus fine et présente une morphologie beaucoup plus homogène.

Dans une telle réalisation illustrée sur les figures 5A et 5B, on admet la présence d'une couche sacrificielle SAC ayant une épaisseur donnée. Toutefois, en variante de la réalisation illustrée sur les figures 5A et 5B, il est possible de « terminer » la couche de molybdène par la couche barrière MO-EA (donc j=N, selon les notations ci-avant). Dans ces conditions, il a été observé par microscopie TEM qu'une couche superficielle de MoSe₂ est néanmoins obtenue, mais qu'elle est très fine (d'épaisseur inférieure à 10 nm).

Ainsi, la présente invention permet de contrôler notamment l'épaisseur de la couche superficielle SUP, voire la réduire à une épaisseur de l'ordre de quelques nanomètres.

L'épaisseur de la couche superficielle peut donc être optimisée selon des choix de mise en œuvre. Elle peut être réduite à un ordre de moins de 10 nm si la couche barrière est à l'interface avec les précurseurs I-III. Une telle épaisseur peut déjà suffire à conférer les propriétés recherchées dans cette couche de Mo-VI (bonne qualité de contact, efficacité d'une gravure laser, et/ou autres).

Plus généralement, l'épaisseur de la couche superficielle peut ainsi être contrôlée plus finement que dans l'état de l'art. Comme indiqué ci-avant, les mesures d'épaisseurs de cette couche par microscopie TEM notamment ont révélé une homogénéité d'épaisseur améliorée dans le plan de la couche par rapport à l'état de l'art existant, avec une variation moyenne inférieure à 10%, ce qui montre en outre une amélioration de la morphologie de la couche superficielle obtenue par la mise en œuvre du procédé de l'invention.

L'épaisseur de la couche Mo en contact avec le substrat est habituellement de l'ordre de 450 nm pour garantir une bonne conductivité et aider ainsi à la réalisation d'une bonne homogénéité en électro-dépôt des précurseurs I et III. Elle pourrait toutefois être réduite au regard de l'amélioration des performances d'électro-dépôt obtenues avec une couche superficielle SUP au sens de l'invention, ce qui permettrait alors une réduction des coûts de fabrication (notamment des coûts de dépôt en molybdène).

Une épaisseur de 50 nm pour la couche barrière MO-EA peut être prévue. Néanmoins, l'optimisation du taux de nitruration du molybdène relativement à l'épaisseur de la couche barrière peut permettre une réduction de l'épaisseur de la couche barrière et, de là, une réduction encore des coûts de fabrication. A cet effet, il convient de contrôler le débit de gaz N₂ dans le plasma d'argon (en %), tout en conservant les mêmes paramètres du procédé (en pression, puissance, etc.).

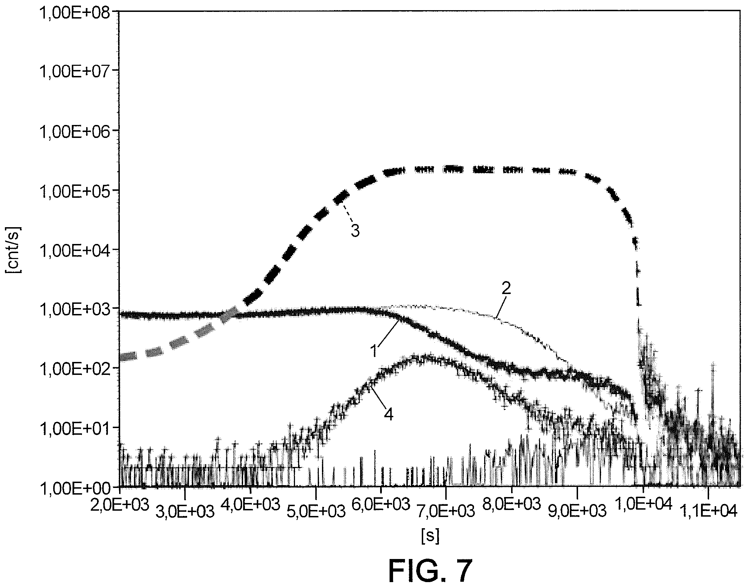

On a représenté sur la figure 7 les courbes comparatives de mesures SIMS (pour « Secondary Ion Mass Spectroscopy ») réalisées sur du sélénium (avec couche barrière : courbe 1 et sans couche barrière : courbe 2), la courbe 3 illustrant les mesures sur le molybdène (à titre indicatif et en traits pointillés) et la courbe 4 les mesures sur l'azote. Les courbes SIMS sont à interpréter en rappelant que le début des courbes (à gauche) correspond à la surface supérieure des couches, tandis que la fin des courbes (à droite) correspond à l'interface en profondeur des couches. Ainsi, il est manifeste ici que le renflement observé sur la courbe 2 du sélénium (sans barrière), avec toutefois un fort niveau de signal pour le molybdène (courbe 3), est lié à une forte présence de sélénium dans la couche de molybdène, en l'absence de barrière. En revanche, en présence d'élément azote pour former la couche barrière (courbe 4), on constate une nette diminution de présence de sélénium (courbe 1).

Bien entendu, la présente invention ne se limite pas à la forme de réalisation décrite ci-avant à titre d'exemple illustratif ; elle s'étend à d'autres variantes.

L'espèce atomique formant barrière avec le molybdène peut être de l'azote, ou encore de l'oxygène, ou encore du titane ou du chrome, pour se combiner au molybdène pendant une étape de sa croissance et former une barrière de diffusion à l'élément VI.

Par ailleurs, l'élément VI peut être du sélénium comme décrit précédemment ou encore du soufre.

## Revendications

1. Procédé de fabrication d'une couche I-III-VI₂ à propriétés photovoltaïques, comportant :
- le dépôt sur un substrat de molybdène pour former une couche de contact, le dépôt comprenant une étape pendant laquelle un élément additionnel est ajouté au molybdène pour former un composé (MO-EA), dans la couche de contact, jouant le rôle de barrière de diffusion à l'élément VI,
- le dépôt d'un précurseur de la couche photovoltaïque, sur la couche de contact, et
- un traitement thermique du précurseur avec un apport en élément VI pour former la couche I-III-VI₂, le procédé comprenant le dépôt d'une couche sacrificielle de molybdène sur le composé MO-EA et avant le dépôt du précurseur, ladite couche sacrificielle réagissant avec l'élément VI lors du traitement thermique pour former une couche superficielle entre la couche de contact et la couche photovoltaïque.

2. Procédé selon la revendication 1, **caractérisé en ce que** ladite étape d'ajout d'un élément additionnel est succédée d'un dépôt de molybdène sans ledit élément additionnel.

3. Procédé selon la revendication 1, **caractérisé en ce que** ladite étape d'ajout d'un élément additionnel termine le dépôt de la couche de contact.

4. Procédé selon l'une des revendications précédentes, **caractérisé en ce que** ladite étape d'ajout d'un élément additionnel est précédée d'un dépôt dudit molybdène sans ledit élément additionnel.

5. Procédé selon l'une des revendications précédentes, **caractérisé en ce que** le molybdène est déposé par pulvérisation d'une cible (CT) comportant ledit molybdène, la pulvérisation étant assistée par un plasma comportant ledit élément additionnel pendant ladite étape.

6. Procédé selon l'une des revendications 1 à 4, **caractérisé en ce que** le molybdène est déposé par pulvérisation d'une cible (CT) comportant, pendant ladite étape, le molybdène et l'élément additionnel.

7. Procédé selon l'une des revendications précédentes, **caractérisé en ce que** l'élément additionnel est au moins un élément parmi :
- de l'azote, pour former un nitrure en tant que matériau barrière à l'élément VI,
- de l'oxygène, pour former un oxyde en tant que matériau barrière à l'élément VI, et
- un métal pour former un alliage en tant que matériau barrière à l'élément VI.

8. Procédé selon l'une des revendications précédentes, **caractérisé en ce que** l'élément VI est du sélénium.

9. Cellule photovoltaïque comportant :
- une couche d'alliage d'éléments I, III et VI, ladite couche ayant des propriétés photovoltaïques, et
- une couche de contact de molybdène agencée sur un substrat et sous la couche photovoltaïque, la couche de contact comportant un composé formé à partir dudit molybdène et d'un élément additionnel, ledit composé formant une barrière de diffusion à l'élément VI, et
- une couche superficielle entre la couche photovoltaïque et le composé, la couche superficielle comportant un composé molybdène-élément VI.

## Patentansprüche

1. Verfahren zur Herstellung einer I-III-VI₂-Schicht mit photovoltaischen Eigenschaften, umfassend:
- Ablagerung auf einem Molybdän-Substrat zum Bilden einer Kontaktschicht, wobei die Ablagerung einen Schritt umfasst, bei dem ein zusätzliches Element zu dem Molybdän hinzugefügt wird, um eine Verbindung (MO-EA) in der Kontaktschicht zu bilden, die als Diffusionsbarriere für das Element VI dient,
- Ablagerung eines Vorläufers der Photovoltaik-Schicht auf der Kontaktschicht, und
- Wärmebehandlung des Vorläufers mit einer Zufuhr des Elements VI, um die I-III-VI₂-Schicht zu bilden, wobei das Verfahren die Ablagerung einer Opferschicht aus Molybdän auf der MO-EA-Verbindung und vor der Ablagerung des Vorläufers umfasst, wobei die Opferschicht mit dem Element VI während der Wärmebehandlung reagiert, um eine Oberflächenschicht zwischen der Kontaktschicht und der Photovoltaik-Schicht zu bilden.

2. Verfahren nach Anspruch 1, **dadurch gekennzeichnet, dass** dem Schritt des Hinzufügens eines zusätzlichen Elements eine Ablagerung von Molybdän ohne das zusätzliche Element folgt.

3. Verfahren nach Anspruch 1, **dadurch gekennzeichnet, dass** der Schritt des Hinzufügens eines zusätzlichen Elements die Ablagerung der Kontaktschicht beendet.

4. Verfahren nach einem der vorhergehenden Ansprüche, **dadurch gekennzeichnet, dass** dem Schritt des Hinzufügens eines zusätzlichen Elements eine Ablagerung des Molybdäns ohne das zusätzliche Element vorausgeht.

5. Verfahren nach einem der vorhergehenden Ansprüche, **dadurch gekennzeichnet, dass** das Molybdän durch Sprühen eines Targets (CT), das das Molybdän enthält, abgelagert wird, wobei das Sprühen während dieses Schrittes durch ein Plasma, das das zusätzliche Element enthält, unterstützt wird.

6. Verfahren nach einem der Ansprüche 1 bis 4, **dadurch gekennzeichnet, dass** das Molybdän durch Sprühen eines Targets (CT) abgelagert wird, das während dieses Schrittes das Molybdän und das zusätzliche Element umfasst.

7. Verfahren nach einem der vorhergehenden Ansprüche, **dadurch gekennzeichnet, dass** das zusätzliche Element mindestens ein Element ist aus:
- Stickstoff, um ein Nitrid als Barrierematerial zum Element VI zu bilden,
- Sauerstoff, um ein Oxid als Barrierematerial zum Element VI zu bilden, und
- ein Metall, um eine Legierung als Barrierematerial zum Element VI zu bilden.

8. Verfahren nach einem der vorhergehenden Ansprüche, **dadurch gekennzeichnet, dass** das Element VI Selen ist.

9. Photovoltaik-Zelle, umfassend:
- eine Legierungsschicht aus den Elementen I, III und VI, wobei diese Schicht photovoltaische Eigenschaften aufweist, und
- eine Kontaktschicht aus Molybdän, die auf einem Substrat und unter der Photovoltaik-Schicht angeordnet ist, wobei die Kontaktschicht eine Verbindung umfasst, die aus dem Molybdän und einem zusätzlichen Element gebildet ist, wobei die Verbindung eine Diffusionsbarriere zum Element VI bildet, und
- eine Oberflächenschicht zwischen der Photovoltaik-Schicht und der Verbindung, wobei die Oberflächenschicht eine Verbindung Molybdän-Element VI umfasst.

## Claims

1. Method for fabricating a I-III-VI₂ layer having photovoltaic properties, comprising:
- deposition of molybdenum on a substrate to form a contact layer, the deposition comprising a step of adding an additional element to the molybdenum to form a compound (MO-EO), in the contact layer, acting as a barrier to diffusion of the element VI,
- deposition of a precursor of the photovoltaic layer, on the contact layer, and
- heat treatment of the precursor with an addition of element VI to form the I-III-VI₂ layer,
the method comprising the deposition of a sacrificial molybdenum layer on the compound of MO-EA and before the deposition of the precursor, wherein said sacrificial layer reacts with the element VI during the heat treatment to form a superficial layer between the contact layer and the photovoltaic layer.

2. Method according to claim 1, **characterized in that** said step of adding an additional element is followed by a deposition of molybdenum without said additional element.

3. Method according to claim 1, **characterized in that** said step of adding an additional element ends the deposition of the contact layer.

4. Method according to any one of the above claims, **characterized in that** said step of adding an additional element is preceded by deposition of said molybdenum without said additional element.

5. Method according to any one of the above claims, **characterized in that** the molybdenum is deposited by sputtering a target (CT) containing said molybdenum, the sputtering being assisted by a plasma containing said additional element during said step.

6. Method according to any one of claims 1 to 4, **characterized in that** the molybdenum is deposited by sputtering a target (CT) containing, during said step, the molybdenum and the additional element.

7. Method according to any one of the above claims, **characterized in that** the additional element is at least one element from among:
- nitrogen, to form a nitride as barrier material to the element VI,
- oxygen, to form an oxide as barrier material to the element VI, and
- a metal to form an alloy as barrier material to the element VI.

8. Method according to any one of the above claims, **characterized in that** the element VI is selenium.

9. Photovoltaic cell comprising:
- an alloy layer of elements I, III and VI, said layer having photovoltaic properties, and
- a contact layer, comprising molybdenum disposed on the substrate and under the photovoltaic layer, the contact layer comprising a compound formed of molybdenum and an additional element, said compound forming a barrier to diffusion of the element VI, and
- a superficial layer between the photovoltaic layer and the compound, the superficial layer comprising a compound of molybdenum-element VI.
